# EUROPEAN PATENT APPLICATION

(11) **EP 3 787 387 A1**
(43) Date of publication of application: **03.03.2021**
(21) Application number: 20192123.6
(22) Date of filing: 21.08.2020
(51) Int. Cl.: H05K 7/20

(54) **INVERTER AND HEAT DISSIPATION DEVICE THEREOF**

(30) Priority: 29.08.2019 CN 201921429782 U
(71) Applicant: Sungrow Power Supply Co., Ltd., Hefei, Anhui 230088 (CN)
(72) Inventor: ZHOU, Jie, Hefei, Anhui 230088 (CN); CHEN, Peng, Hefei, Anhui 230088 (CN); HU, Liwen, Hefei, Anhui 230088 (CN); AI, Pengli, Hefei, Anhui 230088 (CN); WANG, Peng, Hefei, Anhui 230088 (CN); TAO, Gaozhou, Hefei, Anhui 230088 (CN)
(74) Representative: Epping - Hermann - Fischer

(57) **Abstract**

A heat dissipation device of an inverter is provided disclosed by the present application, which includes a heat sink base, a cooling module and a temperature equalizing plate arranged on the heat sink base. The cooling module is configured to dissipate heat from the heat sink base, the temperature equalizing plate is provided with a part mounting seat, and the heat sink base is arranged between the cooling module and the temperature equalizing plate. When in use, the heat sink base is mounted on the cooling module, the temperature equalizing plate is mounted on the heat sink base, and a part is mounted on the part mounting seat. In the heat dissipation device provided by the present application, since the temperature equalizing plate serves as a two-dimensional planar heat-conduction structure, the heat of the part is dissipated through the entire surface of the temperature equalizing plate, and then the heat is conducted to the heat sink base and the cooling module far more quickly. Therefore, the heat dissipation efficiency of the heat dissipation device is improved.

## Description

### FIELD

The present application relates to the technical field of heat dissipation of electrical appliances, in particular to a heat dissipation device of an inverter. The present application further relates to an inverter which includes the above heat dissipation device.

### BACKGROUND

The major power devices of electrical equipment generate heat during normal operation. In order to ensure that these equipment work within a suitable temperature range, corresponding heat dissipation measures should be taken.

A conventional heat dissipation device of an inverter includes a heat sink base and cooling modules for dissipating heat from the heat sink base. Heat pipes are soldered on the heat sink base and devices are installed on the heat pipes.

Due to one dimensional heat conduction capacity of heat pipes and limited heat conduction power of one single pipe, there are large limitations in heat dissipation. Moreover, in actual product applications, due to the influence of processing auxiliary holes or positions of mounting holes, only the bending process can be used. When the heat pipe is bent, the heat transfer performance thereof will be reduced to a certain extent, resulting in reduced heat dissipation efficiency of the heat dissipation device.

Therefore, a technical problem urgently to be solved by those skilled in the art is how to improve the heat dissipation efficiency of the heat dissipation device.

### SUMMARY

An object of the present application is to provide a heat dissipation device of an inverter with improved heat dissipation efficiency. Another object of the present application is to provide an inverter including the above heat dissipation device.

In order to achieve the above objects, a heat dissipation device of an inverter is provided according to the present application, which includes a heat sink base, a cooling module for dissipating heat from the heat sink base, and a temperature equalizing plate arranged on the heat sink base. The temperature equalizing plate is provided with a part mounting seat, and the heat sink base is arranged between the cooling module and the temperature equalizing plate.

Preferably, multiple part mounting seats are provided on the temperature equalizing plate.

Preferably, distances between any two adjacent part mounting seats are the same.

Preferably, multiple temperature equalizing plates and multiple part mounting seats are provided, and the multiple part mounting seats and the multiple temperature equalizing plates are in one-to-one correspondence.

Preferably, multiple heat sink bases and multiple cooling modules are provided, the multiple heat sink bases and the multiple cooling modules are in one-to-one correspondence, and the multiple cooling modules and the multiple temperature equalizing plates are in one-to-one correspondence.

Preferably, the heat dissipation device further includes a heat pipe and/or a thermal interface material layer arranged on the heat sink base.

Preferably, the temperature equalizing plate is fixedly connected to the heat sink base by welding or bonding.

Preferably, the temperature equalizing plate is fixedly connected to the heat sink base by threaded fasteners, and a heat-conduction silicone grease layer is provided between the temperature equalizing plate and the heat sink base.

Preferably, the temperature equalizing plate includes an upper heat-conduction plate and a cellular heat-conduction support plate provided below the upper heat-conduction plate, and the part mounting seat is arranged on the upper surface of the upper heat-conduction plate.

Preferably, the cooling module is a cooling fin or a liquid-cooled substrate.

An inverter includes a power supply device and a heat dissipation device for dissipating heat from the power supply device, and the heat dissipation device is the described heat dissipation device according to any of the above aspects.

Preferably, the inverter further includes a sealed chamber for placing the power supply device. The temperature equalizing plate is located inside the sealed chamber, and the heat sink base is located outside the sealed chamber.

In the above technical solutions, the heat dissipation device of an inverter provided by the present application includes the heat sink base, the cooling module and the temperature equalizing plate arranged on the heat sink base, wherein the cooling module is configured to dissipate heat from the heat sink base, the temperature equalizing plate is provided with the part mounting seat, and the heat sink base is arranged between the cooling module and the temperature equalizing plate. When in use, the heat sink base is mounted on the cooling module, the temperature equalizing plate is mounted on the heat sink base, and parts of the device are mounted on the part mounting seat.

As can be seen from the above description, in the heat dissipation device provided by the present application, since the temperature equalizing plate serves as a two-dimensional planar heat-conduction structure, the heat of the part is dissipated through the entire surface of the temperature equalizing plate, and then the heat is conducted to the heat sink base and the cooling module far more quickly. Therefore, the heat dissipation efficiency of the heat dissipation device is improved.

### BRIEF DESCRIPTION OF THE DRAWINGS

For more clearly illustrating the technical solutions in the embodiments of the present application or in the conventional technology, drawings referred to for describing the embodiments or the conventional technology will be briefly described hereinafter. The drawings in the following description are only examples of the present application, and for those skilled in the art, other drawings may be obtained based on the provided drawings without any creative efforts.
Figure 1 is a schematic structural view of a heat dissipation device according to a first embodiment of the present application;
Figure 2 is a schematic structural view of the heat dissipation device according to a second embodiment of the present application;
Figure 3 is a schematic structural view of a heat dissipation device according to a third embodiment of the present application;
Figure 4 is a schematic structural view of an inverter according to an embodiment of the present application.

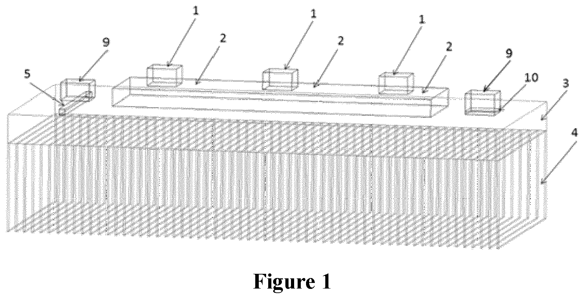

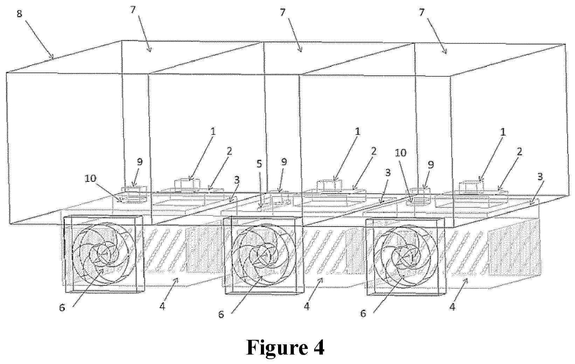

Reference numerals in Figures 1 to 4 are listed as follows:

| | |
|---|---|
| 1 first part, | 2 emperature equalizing plate, |
| 3 heat sink base, | 4 cooling module, |
| 5 heat pipe, | 6 power device, |
| 7 sealed chamber, | 8 power supply device, |
| 9 second part, | 10 thermal interface material layer. |

### DETAILED DESCRIPTION OF THE EMBODIMENTS

A core of the present application is to provide a heat dissipation device of an inverter with improved heat dissipation efficiency. Another core of the present application is to provide an inverter including the above heat dissipation device.

In order to make those skilled in the art better understand technical solutions of the present application, the present application will be described in detail hereinafter in conjunction with the drawings and specific embodiments.

Reference is made to Figure 1 to Figure 4.

In a specific embodiment, a heat dissipation device of an inverter provided by the present application includes a heat sink base 3, a cooling module 4 and a temperature equalizing plate 2 arranged on the heat sink base 3, wherein the cooling module 4 is configured to dissipate heat from the heat sink base 3, the temperature equalizing plate 2 is provided with a part mounting seat, and the heat sink base 3 is arranged between the cooling module 4 and the temperature equalizing plate 2. The temperature equalizing plate 2 is also called VC (Vapor Chamber). Specifically, as shown in Figure 1, projecting vertically downwards, the projection of a heat dissipation surface of a first part 1 is located within the projection range of the temperature equalizing plate 2, thus improving the heat dissipation effect of the first part.

Specifically, the temperature equalizing plate 2 may be mounted on the heat sink base 3 by welding, bonding, or threaded fasteners, particularly by soldering or screws. In a case that the temperature equalizing plate 2 is connected to the heat sink base 3 by threaded fasteners, in order to improve the heat dissipation effect, it is preferable that a heat-conduction silicone grease layer is provided between the temperature equalizing plate 2 and the heat sink base 3.

Preferably, the heat dissipation device further includes a heat pipe 5 and/or a thermal interface material layer 10 arranged on the heat sink base 3. Specifically, corresponding parts are mounted on the heat pipe 5 and the thermal interface material layer 10 according to actual needs.

Specifically, the cooling module 4 may be a liquid-cooled substrate.

In another embodiment, the cooling module 4 includes cooling fins and a fan for dissipating heat from the cooling fins. When used for dissipating heat from the inverter, the cooling fins are installed outside a sealed chamber 7 where a power supply device 8 of the inverter is located, and are in direct contacting with the air. The heat sink base 3 is installed at a lower portion of the temperature equalizing plate 2. The inside of the power supply device 8 is composed of one or more sealed chambers, the protection level of the sealed chamber 7 is higher than that of the external, the temperature equalizing plate 2 is located in the sealed chamber 7, and the heat sink base 3 is located outside the sealed chamber 7.

When in use, the heat sink base 3 is mounted on the cooling module 4, the temperature equalizing plate 2 is mounted on the heat sink base 3, and the part is mounted on the part mounting seat.

As can be seen from the above description, in the heat dissipation device provided by the specific embodiments of the present application, since the temperature equalizing plate 2 serves as a two-dimensional planar heat-conduction structure, the heat of the part is dissipated through the entire surface of the temperature equalizing plate, and then the heat is conducted to the heat sink base 3 and the cooling module 4 far more quickly. Therefore, the heat dissipation efficiency of the heat dissipation device is improved.

The temperature equalizing plate 2 overcomes the limitation of the one-dimensional heat conduction of the heat pipes 5 and the potential quality hazard of unqualified flatness of the mounting surface due to multiple heat pipes 5. The temperature equalizing plate 2 is not affected by positions of various holes and especially the shape of the mounting surface of the heat sink base 3, and can be made into any shape, which has the advantage of flexible structure.

In order to realize heat dissipation for multiple parts, the temperature equalizing plate 2 may be provided with multiple part mounting seats. Preferably, distances between any two adjacent part mounting seats are the same.

As shown in Figure 1, the temperature equalizing plate 2 is of an independent structure with multiple first parts arranged on. If there are other heat sources, for example, second parts 9, the heat pipe 5 and/or the thermal interface material layer 10 may be provided to realize parallel use of multiple heat dissipation methods.

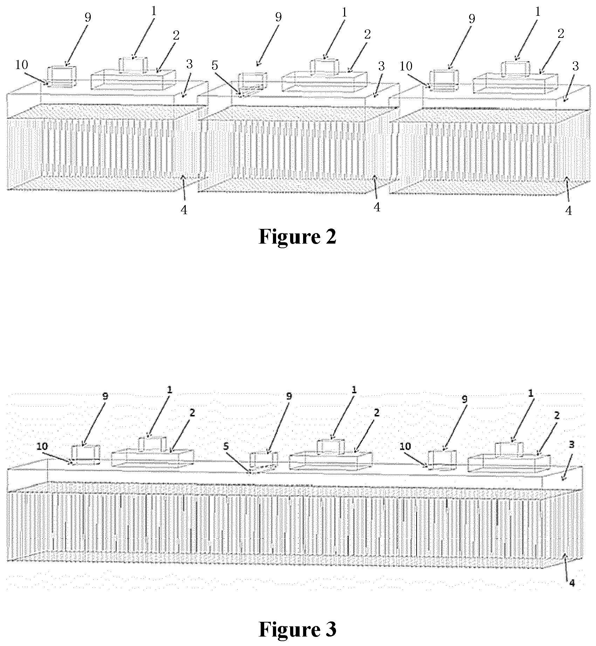

As shown in Figure 3, multiple temperature equalizing plates 2 and multiple part mounting seats are provided, and the multiple part mounting seats and the multiple temperature equalizing plates 2 are in one-to-one correspondence. Specifically, two or three temperature equalizing plates 2 may be provided. If there are other heat sources, for example, second parts 9, the heat pipe 5 and/or the thermal interface material layer 10 may be provided to realize parallel use of multiple heat dissipation methods. Preferably, at least one heat pipe 5 or thermal interface material layer 10 is provided between two adjacent temperature equalizing plates 2.

As shown in Figure 2, multiple heat sink bases 3 and multiple cooling modules 4 are provided, the multiple heat sink bases 3 and the multiple cooling modules 4 are in one-to-one correspondence, and the multiple cooling modules 4 and the multiple temperature equalizing plates 2 are in one-to-one correspondence. If there are other heat sources, for example, second parts 9, the heat pipe 5 and/or the thermal interface material layer 10 may be provided to realize parallel use of multiple heat dissipation methods. Preferably, at least one heat pipe 5 or thermal interface material layer 10 is provided between two adjacent temperature equalizing plates 2. Preferably, at least one heat pipe 5 or thermal interface material layer 10 is provided on each heat sink base 3.

Specifically, the temperature equalizing plate 2 includes an upper heat-conduction plate and a cellular heat-conduction support plate provided below the upper heat-conduction plate, and the part mounting seat is arranged on an upper surface of the upper heat-conduction plate.

An inverter provided by the present application includes a power supply device 8 and a heat dissipation device for dissipating heat from the power supply device 8. The heat dissipation device is the described heat dissipation device according to any of the above embodiments. The specific structure of the heat dissipation device has been described above. Since the inverter includes the above-mentioned heat dissipation device, the inverter also has the above technical effects.

When the power supply device 8 is in operation, the heat generated by the parts in the sealed chamber 7 is conducted to the heat sink base 3 through the temperature equalizing plate 2 and preferably also through the heat pipe 5 or the thermal interface material layer 10. Then most of the heat is conducted to the cooling module 4 through the heat sink base 3. Preferably, the heat accumulated on the heat sink base 3 and the cooling module 4 is conducted to the outside of the power supply device 8 through a power device 6 of the power supply device 8 to achieve heat dissipation. If the cooling module 4 includes heat dissipation fins, it is preferable that the power device 6 is a fan.

In the present specification, the embodiments are described in a progressive manner. Each embodiment mainly focuses on an aspect different from other embodiments, and reference can be made to these similar parts among the embodiments.

Based on the above description of the disclosed embodiments, those skilled in the art can embody or exploit the present application. Various modifications to these embodiments are apparent to those skilled in the art, and the general principles defined herein may be implemented in other embodiments without departing from the spirit or scope of the present application. Therefore, the present application is not limited to these embodiments illustrated herein, but should be defined by the broadest scope consistent with the principle and novel features disclosed herein.

## Claims

1. A heat dissipation device of an inverter, comprising a heat sink base (3), and a cooling module (4) for dissipating heat from the heat sink base (3), **characterized in that** the heat dissipation device further comprises a temperature equalizing plate (2) arranged on the heat sink base (3), the temperature equalizing plate (2) is provided with a part mounting seat, and the heat sink base (3) is arranged between the cooling module (4) and the temperature equalizing plate (2).

2. The heat dissipation device of the inverter according to claim 1, wherein a plurality of part mounting seats are provided on the temperature equalizing plate (2).

3. The heat dissipation device of the inverter according to claim 2, wherein distances between any two adjacent part mounting seats are the same.

4. The heat dissipation device of the inverter according to claim 1, wherein a plurality of temperature equalizing plates (2) and a plurality of part mounting seats are provided, and the plurality of part mounting seats and the plurality of temperature equalizing plates (2) are in one-to-one correspondence.

5. The heat dissipation device of the inverter according to claim 4, wherein a plurality of heat sink bases (3) and a plurality of cooling modules (4) are provided, the plurality of heat sink bases (3) and the plurality of cooling modules (4) are in one-to-one correspondence, and the plurality of cooling modules (4) and the plurality of temperature equalizing plates (2) are in one-to-one correspondence.

6. The heat dissipation device of the inverter according to claim 1, further comprising a heat pipe (5) and/or a thermal interface material layer (10) arranged on the heat sink base (3).

7. The heat dissipation device of the inverter according to claim 1, wherein, the temperature equalizing plate (2) is fixedly connected to the heat sink base (3) by welding or bonding.

8. The heat dissipation device of the inverter according to claim 1, wherein, the temperature equalizing plate (2) is fixedly connected to the heat sink base (3) by threaded fasteners, and a heat-conduction silicone grease layer is provided between the temperature equalizing plate (2) and the heat sink base (3).

9. The heat dissipation device of the inverter according to claim 1, wherein the temperature equalizing plate (2) comprises an upper heat-conduction plate and a cellular heat-conduction support plate provided below the upper heat-conduction plate, and the part mounting seat is arranged on an upper surface of the upper heat-conduction plate.

10. The heat dissipation device of the inverter according to any one of claims 1 to 9, wherein the cooling module (4) is a cooling fin or a liquid-cooled substrate.

11. An inverter, comprising a power supply device (8) and a heat dissipation device for dissipating heat from the power supply device (8), wherein the heat dissipation device is the heat dissipation device according any one of claims 1 to 10.

12. The inverter according to claim 11, further comprising a sealed chamber (7) for placing the power supply device (8), wherein the temperature equalizing plate (2) is located inside the sealed chamber (7), and the heat sink base (3) is located outside the sealed chamber (7).
